Europäisches Patentamt

European Patent Office

Office européen des brevets

(11) Numéro de publication: **0 304 362 B1**

## (12) FASCICULE DE BREVET EUROPEEN

(45) Date de publication de fascicule du brevet: **07.01.93** (51) Int. Cl.5: **H04B 3/23**, G06F 15/336, H04L 25/03, H03H 17/02

(21) Numéro de dépôt: **88401951.4**

(22) Date de dépôt: **27.07.88**

(54) Dispositif de calcul numérique pour installation de transmission de données en code 2B 1O ou analogue.

(30) Priorité: **30.07.87 FR 8710821**

(43) Date de publication de la demande:
**22.02.89 Bulletin 89/08**

(45) Mention de la délivrance du brevet:
**07.01.93 Bulletin 93/01**

(84) Etats contractants désignés:
**DE GB NL**

(56) Documents cités:
**EP-A- 0 081 437**
**US-A- 4 121 296**

**IEEE TRANSACTIONS ON COMMUNICA-
TIONS, vol. COM-32, no. 9, septembre 1984,
pages 1025-1033, IEEE, New York, US; G. PIRANI et al.: "Adaptive multiplication-free
transversal equalizers with application to digital radio systems"**

(73) Titulaire: **Rault, Jean-Christophe**
**28 Rue des Bons Enfants**
**F-22700 Perros-Guirec(FR)**

(72) Inventeur: **Rault, Jean-Christophe**
**28 Rue des Bons Enfants**
**F-22700 Perros-Guirec(FR)**

(74) Mandataire: **Fort, Jacques et al**
**CABINET PLASSERAUD 84, rue d'Amsterdam**
**F-75009 Paris(FR)**

Rank Xerox (UK) Business Services

**Description**

L'invention concerne les dispositifs de calcul numérique permettant de calculer en temps réel une somme de termes de la forme :

$$\Sigma \hat{h}(iT) . \hat{q}e((n-i)T)$$

dans laquelle

T désigne une période d'échantillonnage,

$\hat{h}(iT)$ des coefficients, et

$$\hat{q}e$$

les valeurs estimées de données émises qe pouvant prendre les valeurs -3, -1, +3 et +1.

Le problème du calcul d'une telle somme se pose notamment dans la réalisation de filtres linéaires utilisables dans des annuleurs d'écho (qu'on désignera par la suite par l'abréviation habituelle ECC) pour installation de transmission numérique de données en code 2B1Q. On sait que ce code, susceptible d'être adapté comme standard à la suite de la normalisation de l'interface U aux Etats- Unis, associe à chaque ensemble de deux élément binaires, dit "dibit", un niveau parmi quatre, suivant le tableau :

| dibit | niveau émis |
|-------|-------------|
| OO | -3 |
| O1 | -1 |
| 10 | +3 |
| 11 | +1 |

Les données qe(t) émises en ligne peuvent donc prendre les quatre valeurs ci-dessus. Dans une installation de transmission dont la chaîne a une réponse impulsionnelle h(t), le signal sr(nT) reçu à l'instant nT est :

$$sr(nT) = \sum_{i=0}^{\infty} h(iT).qe((n-i)T) \qquad (1)$$

La recherche de valeurs estimées qe de qe implique, dans une installation de réception, de calculer des sommes de la forme (1). Par exemple chaque fois que les lignes de transmission sont hétérogènes, la décision sur la valeur de qe(nT) ne peut être faite qu'après avoir soustrait, du signal reçu sr(nT), une estimation de l'interférence intersymbole, ou ISI, dont la valeur exacte serait :

$$\sum_{i=1}^{N} h(it) * qe((n-i)T)$$

L'estimation est classiquement faite par un égaliseur récursif adaptatif à décision dans la boucle, fréquemment désigné par l'abréviation DFE, à N coefficients qui calcule le terme Tr(nT) :

$$Tr(nT) = \sum_{i=1}^{N} \hat{h}(iT) . \hat{q}e((n-i)T \qquad (2)$$

où $\hat{h}(iT)$ est le ième coefficient mémorisé dans le DFE (généralement adaptatif), constituant une estimation du ième échantillon de la réponse impulsionnelle h(t).

Le calcul numérique de Tr(nT) impose, si on applique la formule (2) :

N multiplications $\hat{h}(iT)$ * qe((n-i)T), et

N additions.

Si on tient compte du fait que la donnée estimée

$$\hat{qe}$$

peut prendre les valeurs +3, +1, -3 et -1 et est donc codée sur 2 bits, on peut décomposer chaque multiplication en deux additions et un décalage : l'opération 3 * $\hat{h}(iT)$ devient par exemple :

$$\hat{h}(iT) + 2 * \hat{h}(iT)$$

Mais si on peut, grâce à cette transformation, utiliser un dispositif de calcul sans multiplieur, on double le temps de calcul qui passe de N à 2N cycles.

La suppression de multiplications dans les filtres numériques, notamment pour des égaliseurs transverses, en imposant aux coefficients de ne prendre que des valeurs qui sont des puissances de deux, a déjà été proposée, par exemple dans IEEE Transactions on Communications, vol. COM-32, no. 9, septembre 1984, pages 1025-1033, IEEE, New York, US ; G. PIRANI et al. : "Adaptive multiplication-free transversal equalizers with application to digital radio systems". Mais on ne résoud pas pour autant le problème de l'allongement du temps de calcul. On a également proposé (US-A-4 121 296) un filtre numérique permettant de former la somme de produits élémentaires, en imposant à l'un des facteurs du produit de ne prendre que quelques valeurs. Cela ne résoud pas pour autant le problème ci-dessus.

L'invention vise à fournir un dispositif qui tout à la fois ne comporte pas de multiplieur et n'allonge pas sensiblement le temps de calcul. Pour cela elle part d'une analyse complète de la chaîne de transmission et de ses composants, permettant de mettre l'équation (2), ou l'équation correspondante que l'on trouve dans le cas d'un ECC, sous une forme comportant des termes que l'on peut négliger sans conséquences défavorables.

Une première étape consiste à introduire une variable

$$\hat{qde} = 1 + \hat{qe}$$

qui, du fait que

$$\hat{qe}$$

prend les valeurs +3, +1, -3, -1, ne pourra prendre que les valeurs +4, +2, -2, 0 qui sont des puissances de 2. L'équation (2) qui donne Tr(nT) devient, en fonction des valeurs

$$\hat{qde}((n-1)T) :$$

$$Tr(nT) = \sum_{i=1}^{N} \hat{h}(iT) \cdot [\hat{qde}((n-i)T) - 1] \qquad (3)$$

qu'on peut encore écrire

$$Tr(nT) = \sum_{i=1}^{N} \hat{h}(iT) \cdot \widehat{qde}((n-i)T)$$

$$- \sum_{i=1}^{N} \hat{h}(iT) \qquad (4)$$

:

Le second terme de l'équation (4) peut être transformé si on tient compte que, la chaîne de transmission ne laissant pas passer la composante continue du signal, le gain total de la chaîne

$$\sum_{i=0}^{\infty} \hat{h}(iT)$$

pour cette composante est nul. Or ce gain peut s'écrire

$$\hat{h}(0) + \sum_{i=1}^{N} \hat{h}(iT) + \sum_{i=N+1}^{\infty} \hat{h}(iT) = 0 \qquad (5)$$

Par ailleurs, le terme

$$\sum_{i=N+1}^{\infty} \hat{h}(iT)$$

peut être négligé, car dans un DFE ayant N coefficients on admet que la valeur de la traînée au delà de NT n'a pas à être prise en considération. L'équation (5) fait donc apparaître qu'on peut remplacer

$$- \sum_{i=1}^{N} \hat{h}(iT)$$

dans (4) par h(0). L'équation (4) devient donc :

$$Tr(nT) = \sum_{i=1}^{N} \hat{h}(iT) \cdot \widehat{qde}((n-i)T) + \hat{h}(0) \qquad (6)$$

Le premier terme de l'équation (6) se calcule par N additions et des décalages éventuels suivant la valeur de

$$\widehat{qde},$$

puisque

$$\widehat{qde}$$

4

est toujours une puissance de 2 ; l'addition du second terme se traduit par un allongement d'un seul cycle de calcul. Au total N + 1 cycles suffisent au lieu de 2N cycles dans le cas de l'équation (2).

En conséquence l'invention propose un dispositif de calcul comprenant des moyens pour transformer les valeurs

$$\hat{qe}$$

en des valeurs

$$\widehat{qde}$$

qui sont des puissances de 2, par addition (ou soustraction) d'un même nombre à toutes (ou de toutes) les valeurs ; des moyens pour calculer les produits élémentaires obtenus par des décalages éventuels de h suivant la valeur de

$$\widehat{qde} \quad ;$$

des moyens pour faire la somme des produits élémentaires et des moyens pour y ajouter éventuellement une constante constituant une évaluation de la différence de résultat dû au changement de variable.

Dans le cas évoqué ci-dessus où le dispositif constitue un égaliseur récursif adaptatif fonctionnant suivant l'équation (6) ladite constante constitue une évaluation $\hat{h}(0)$ du premier terme de la fonction de transfert. Les valeurs $\hat{h}$ peuvent être adaptées en permanence par un réseau de type connu, utilisant par exemple l'algorithme du gradient ou du signe.

Dans le cas où le dispositif doit être utilisé comme annuleur d'écho, l'écho synthétisé Ec(nT) est donné par une formule similaire à l'équation (2), faisant intervenir N coefficients évalués qui seront désignés par $\hat{g}$-(iT). avec qe = +3,

$$Ec(nT) = \sum_{i=0}^{N-1} \hat{g}(iT) * \hat{qe}((n-i)T) \qquad (2 \text{ bis})$$

+1, -1 ou -3.

Là encore, pour calculer Ec(nT) par cette formule sans multiplication, il faudrait 2N cycles de calcul.

Un dispositif suivant l'invention effectue un changement de variable sur les données émises qe : on pose

$$\widehat{qde}((n-i)T) = 1 + qe((n-i)T)$$

$$\widehat{qde}$$

ne peut alors prendre que des valeurs +4, +2, 0 et -2. L'écho s'écrit :

$$Ec(nT) = \sum_{i=0}^{N-1} \hat{g}(iT) * [\widehat{qde}((n-i)T)-1] \qquad (3 \text{ bis})$$

ou encore :

5

$$Ec(nT) = \sum_{i=0}^{N-1} \hat{g}(iT) * \widehat{qde}((n-i)T) - \sum_{i=0}^{N-1} \hat{g}(iT) \qquad (4\ bis)$$

Le second terme de l'équation peut être remplacé par :

$$\sum_{i=N}^{\infty} \hat{g}(iT)$$

car le gain de la chaîne d'écho à fréquence nulle

$$\sum_{i=0}^{\infty} \hat{g}(iT)$$

est nul, or dans un annuleur d'écho de longueur NT, on admet que l'énergie d'écho est nulle au delà de NT, donc que

$$\sum_{i=N}^{\infty} \hat{g}(iT) = 0$$

L'écho Ec(nT) se limite donc au premier terme de l'équation (4 bis) c'est-à-dire à :

$$Ec(nT) = \sum_{1=0}^{N-1} \hat{g}(iT) \cdot \widehat{qde}((n-i)T) \qquad (6bis)$$

On peut encore poser ici :

$$\widehat{q'de}(i) = 1/2\ \widehat{qde}(i)$$

et dans ce cas

$$\widehat{q'de}(i)$$

peut prendre uniquement les valeurs -1, 0, 1 ou 2 ; et si on utilise des coefficients $\hat{g}'(i) = 2\hat{g}(i)$ l'équation (6 bis) peut s'écrire :

$$Ec(nT) = \sum_{i=0}^{N-1} \hat{g}'(iT) \cdot \widehat{q'de}((n-i)T) \qquad (6\ ter)$$

On constate ainsi que, moyennant la mémorisation des coefficients d'ECC doubles, les produits qui interviennent dans la somme peuvent être implantés :

- par génération de zéro pour

$$\widehat{qde} = 0,$$

- par transparence (égalité de la sortie et de l'entrée avec changement de signe éventuel) pour

$$\widehat{qde} = 2$$

ou -2,
- par décalage d'un bit vers les poids forts pour

$$\widehat{qde} = \overline{4}.$$

L'invention sera mieux comprise à la lecture de la description qui suit d'un mode particulier d'exécution de l'invention, donné à titre d'exemple non limitatif et à la comparaison qui en est faite avec un dispositif connu. La description se réfère aux dessins qui l'accompagnent dans lesquels :
- la figure 1 est un schéma de principe d'un dispositif de calcul utilisable dans un ECC, de type connu ;
- la figure 2 similaire à la figure 1, est un schéma d'un ECC suivant l'invention.

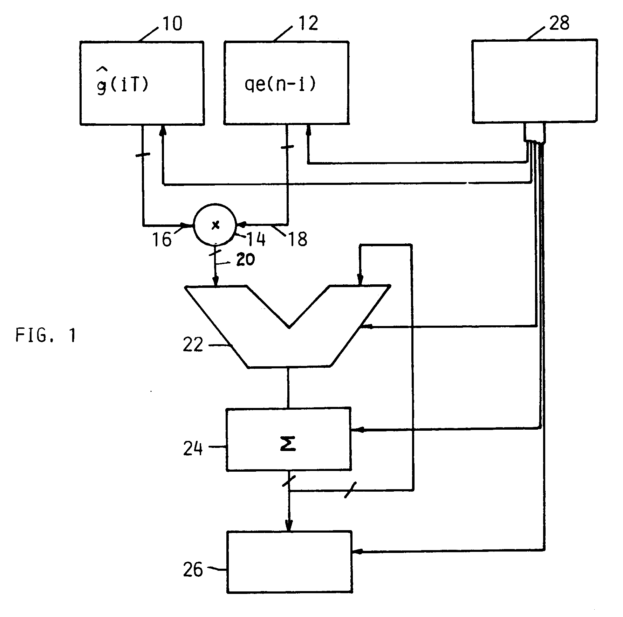

Le dispositif de la figure 1, qu'on supposera destiné à calculer en temps réel des valeurs successives estimées d'un écho Ec(nT) met en oeuvre la fonction (2 bis) ci-dessus, c'est-à-dire :

$$Ec(nT) = \sum_{i=0}^{N-1} \widehat{g}(iT) . qe((n-i)T)$$

où
$\widehat{g}(iT)$ pour i = 0 , ..., N-1 sont les N coefficients du filtre d'écho,
qe((n-i)T) pour i = 0, ..., N-1, sont les N dernières données émises en code 2B1Q.

Pour simplifier l'écriture, on utilisera dans ce qui suit la notation qe(n-i) au lieu de qe((n-i)T).

Le dispositif montré en figure 1 comporte une mémoire 10 de stockage des coefficients $\widehat{g}(iT)$. Cette mémoire sera généralement une mémoire vive associée à un filtre adaptatif de calcul des coefficients par un algorithme d'adaptation qui peut être connu. On trouvera des exemples de tels filtres dans de nombreux documents, tels que par exemple le document US-A-4 564 934 (MACCHI).

Une seconde mémoire vive 12, comportant souvent un registre à décalage, reçoit les N dernières données estimées qe(n-i), codées sur 2 bits en 2B1Q.

Les entrées d'un multiplieur 14 sont reliées l'une au bus de données 16 de la mémoire 10 des coefficients, l'autre au bus de sortie 18 de la mémoire de données 12. Le bus 20 du multiplieur est relié à une des deux entrées d'un circuit additionneur/soustracteur 22. Un registre 24 d'accumulation de résultats fourni par l'additionneur/soustracteur est placé à la sortie de ce dernier. Il contient en permanence le résultat de la dernière opération et alimente un second registre 26 et la seconde entrée de l'additionneur/soustracteur. Le second registre 26 mémorise le contenu du registre 24 lorsque celui-ci contient le résultat final de l'opération : il contient alors le résultat Ec(nT) qui peut alors être lu soit par un autre calculateur, soit par un convertisseur numérique/analogique (non représenté). Un circuit 28 constituant base de temps et contenant une mémoire de programme permet de séquencer les opérations de calcul en activant les circuits 10, 12, 22, 24 et 26. La somme :

$$Ec(nT) = \sum_{i=0}^{N-1} \widehat{g}(iT) . qe(n-i)$$

est calculée en N cycles de calcul de la façon suivante, après remise à zéro de 24 et 26 par la base de temps.

Cycle 1 :   lecture de $\widehat{g}(0)$ et de qe(nT) dans les mémoires 10 et 12 ;
                 multiplication de $\widehat{g}(0)$ par qe(n) dans 14 ;
                 êcriture du résultat $\widehat{g}(0).qe(n)$ dans le registre 24.
Cycle 2 :   lecture de $\widehat{g}(1T)$ et de qe(n-1) dans les mémoires ;
                 multiplication de $\widehat{g}(1T)$ par qe(n-1) ;

addition de la sortie du multiplieur avec le contenu du registre 24, c'est-à-dire $\hat{g}(0).qe(n)$ ;
écriture du résultat dans le registre 24.

........

Cycle N :    lecture de $\hat{g}((N-1)T)$ et de qe(n-N + 1) dans les mémoires ;

multiplication de $\hat{g}(N-1)$ par qe(n-N + 1) ;

addition de la sortie du multiplieur avec le contenu du registre 24

$$\sum_{j=0}^{N-2} \hat{g}(j)qe(n-j)$$

écriture du résultat

$$\sum_{j=0}^{n-1} \hat{g}(j)qe(n-j)$$

dans le registre 24.

Enfin, à l'issue du Nème cycle, la base de temps provoque le transfert du résultat du registre 24 au registre de sortie 26.

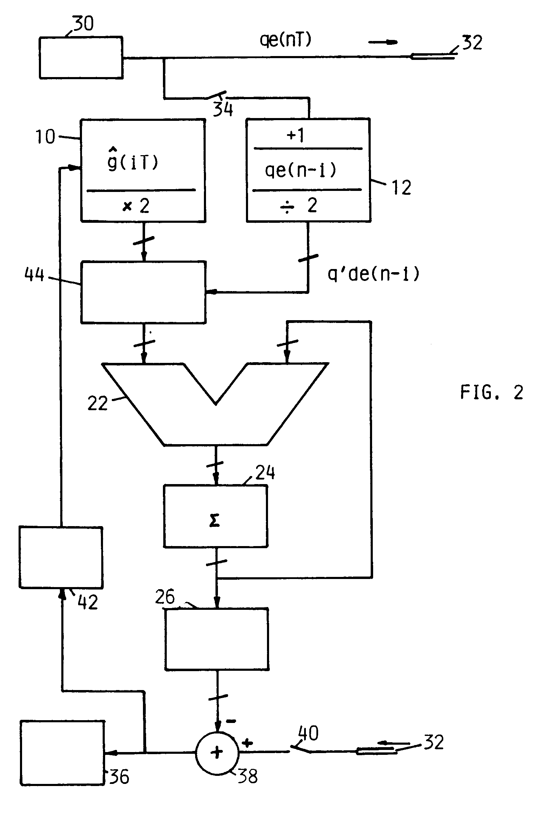

Le dispositif suivant l'invention montré schématiquement en figure 2 permet de remplir la même fonction que celui de la figure 1, sans augmentation du volume de mémoire nécessaire au calcul de Ec(nT), avec le même nombre N de cycles de calcul pour chaque valeur et sans multiplieur.

Sur la figure 2, la base de temps et la mémoire de programme n'ont pas été représentées pour plus de simplicité. Les organes correspondant à ceux de la figure 1 portent le même numéro de référence. De plus, pour illustrer la disposition de l'annuleur d'écho dans une station, la figure 2 montre schématiquement un émetteur 30 fournissant les données successives qe(nT) vers une ligne de transmission 32. Un échantillonneur 34 prélève des échantillons successifs qui sont mémorisés dans la mémoire 12 munie d'un additionneur et d'un diviseur par 2 permettant d'obtenir $q'de$. Les signaux provenant de la ligne sont appliqués au récepteur 36 par l'intermédiaire d'un organe de calcul 38 constituant additionneur dont l'entrée additive reçoit des échantillons découpés sur le signal reçu par un échantillonneur 40 et l'entrée soustractive, la sortie de la mémoire 26. En général le dispositif comportera un circuit 42 d'adaptation des coefficients $\hat{g}(iT)$ de l'annuleur d'écho.

Cette disposition de l'annuleur d'écho dans une station d'émission/réception associée à une ligne de transmission en duplex est classique : on pourra en trouver une description plus complète, en cas de besoin, dans l'article de FALCONER et autres "Adaptive echo cancellation AGC structures for two wire full duplex data transmission" dans Bell Technical Journal, volume 58, n° 7, septembre 1979, page 1593 ou dans le brevet US 4 564 934 déjà mentionné.

Le dispositif de la figure 2 calcule l'écho Ec(nT) en appliquant la formule (6 ter) ci-dessus. Le multiplieur 14 est remplacé par un circuit 44 très simple, puisqu' il applique, au coefficient $\hat{g}(iT)$, l'une de trois fonctions, sélectionnée par les deux bits de données correspondant à

$$\widehat{q'de}$$

qui est obtenu par simple décalage des valeurs

$$\widehat{qde}$$

d'une position vers la droite. Les trois opérations possibles sont :
- transfert pur et simple de l'entrée vers la sortie (fonction transparence) équivalente à une multiplication par 1, lorsque

$$\widehat{q'de}(n-i) = 1 \text{ ou } -1 \text{ ;}$$

8

- décalage de la donnée de 1 bit vers les poids forts, équivalent à une multiplication par 2, lorsque

$$\widehat{q'de}(n-i) = 2 \ ;$$

- génération d'un zéro en sortie, c'es-à-dire multiplication par zéro ou effacement, lorsque

$$\widehat{q'de}(n-i) = 0.$$

De plus, une opération de changement de signe doit être effectuée lorsque

$$\widehat{q'de} = -1.$$

On voit que chaque opération est réalisable en un seul cycle. Par exemple le cycle i + 1 est le suivant :
lecture de $\widehat{g}'$ (iT) et $q'de((n\text{-}i)T)$ dans les mémoires,
décalage de $\widehat{g}'$(iT) par 1 bit, ou génération de zéro, ou "transparence";
addition de la sortie de 44 avec le contenu du registre 24 ;
écriture du résultat dans le registre 24.

Cette suite d'opérations pour i = 0 à N-1 réalise le calcul décrit dans l'équation (6 ter).

Par conséquent, sans utiliser de multiplieur, on effectue le calcul en seulement N cycles. Le calculateur fonctionne donc à la même vitesse que dans une réalisation classique, et la quantité de mémoire programme requise ne change pas.

Un dispositif égaliseur ayant la même constitution que l'annuleur d'écho montré schématiquement en figure 2 pourrait être réalisé. Le fonctionnement correspond alors à la formule (6) ci-dessus et la seule opération supplémentaire requise consiste en l'addition du terme estimé $\widehat{h}(0)$ qui dans certains cas pourra être fixé une fois pour toute mais, plus fréquemment, sera en permanence adapté en même temps que les coefficients h(iT) sur la base d'un algorithme classique, tel que l'algorithme du gradient ou du signe.

**Revendications**

**1.** Dispositif de calcul numérique permettant de calculer en temps réel une somme de termes de la forme :

$$\Sigma\widehat{h}(iT).\widehat{qe}((n-i)T)$$

dans laquelle
T désigne une période d'échantillonnage,
$\widehat{h}$(iT) des coefficients, et

$$\widehat{qe}$$

les valeurs estimées de données émises qe pouvant prendre les valeurs -3, -1, + 3 et + 1,
caractérisé en ce qu'il comprend :
  - des moyens pour transformer les valeurs qe en des valeurs qui sont des puissances de 2 par addition ou soustraction d'un même nombre à toutes les valeurs ;

$$\widehat{qde}$$

  - des moyens pour calculer les produits élémentaires obtenus par des décalages éventuels de $\widehat{h}$ suivant la valeur de

$$\widehat{qde} \quad ;$$

- des moyens pour faire la somme des produits élémentaires ; et
- des moyens pour ajouter éventuellement à la somme une constante constituant une évaluation de la différence de résultats due au changement de variable.

**2.** Dispositif selon la revendication 1, caractérisé en ce que les moyens pour transformer les valeurs

$$\widehat{qe}$$

en des valeurs

$$\widehat{qde}$$

sont constitués par un additionneur (12) ajoutant + 1, suivi d'un diviseur par 2 qui forme la valeur

$$\widehat{q'de}$$

égale à 2, 1, 0 ou -1.

**3.** Dispositif selon la revendication 2, caractérisé en ce que les moyens pour calculer les produits élémentaires sont constitués par un circuit (44) permettant, suivant la valeur de

$$\widehat{q'de},$$

d'appliquer à $\widehat{h}$ une des trois fonctions :
- transfert de l'entrée vers la sortie,
- décalage de 1 bit vers les poids forts,
- génération de zéro en sortie.

**4.** Annuleur d'écho comprenant des moyens (34) d'échantillonnage des signaux qe émis sur une ligne à partir d'une station d'émission-réception et des moyens (40) d'échantillonnage des signaux reçus à la station par la ligne,
   caractérisé en ce qu'il comprend :
   un dispositif de calcul numérique permettant de calculer en temps réel une somme de termes de la forme :

$\Sigma \, \widehat{g}(iT) \, . \, q'de((n-i)T)$

   dans laquelle :
   T désigne une période d'échantillonnage,
   $\widehat{g}(iT)$ des coefficients, et
   q'de des valeurs calculées à partir de données émises qe qui ne peuvent prendre que les valeurs -3, -1, +3 et +1, égales à ½(qe + 1), ledit dispositif ayant des moyens (12) pour transformer les valeurs des échantillons qe en des valeurs q'de = ½(qe + 1) qui sont des puissances de deux ; des moyens (44) pour calculer les produits élémentaires obtenus par des décalages éventuels de $\widehat{g}$ suivant la valeur de q'de ; un additionneur (22) dont les entrées sont reliées l'une à la sortie des moyens (44) de calcul des produits élémentaires et l'autre à la sortie d'un registre (24) de totalisation dont l'entrée est reliée à la sortie de l'additionneur, de façon à faire la somme des produits élémentaires ;
   et un organe de calcul (38) recevant d'une part les échantillons des signaux reçus, d'autre part la sortie du registre.

**5.** Annuleur d'écho selon la revendication 4, caractérisé en ce que les moyens (44) pour calculer les produits élémentaires comportent un circuit prévu pour :

- transférer $\hat{g}$(iT) si q'de((n-i)T) est égal à +1 ou -1 en changeant le signe pour la valeur -1,
- décaler $\hat{g}$(iT)de 1 bit vers les poids forts si q'de((n-i)T) est égal à +2,
- générer un zéro en sortie si q'de(n-i) est nul.

**Claims**

1. A digital computing device for computing in real time a sum of terms of the form :

$$\Sigma\hat{h}(iT).\hat{q}e((n-i)T)$$

in which
T designates a sampling period,
$\hat{h}$(iT) coefficients, and

$$\hat{q}e$$

estimated value of transmitted data qe which may have one of the values -3, -1, +3 and +1, characterized in that it comprises :
- means for transforming the values qe into values

$$\hat{qde}$$

which are powers of 2, by addition or subtraction of a same number to or from all the values ;
- means for computing elementary products obtained by possible shifts of $\hat{h}$ depending upon the value of

$$\hat{qde} \ ;$$

- means for summing the elementary products ; and
- means for possibly adding, to the sum, a constant value which is an estimation of the difference in result due to the change in the variable.

2. Device according to claim 1,
characterized in that the means for transforming the value

$$\hat{qe}$$

$$\hat{qde}$$

into value consists of an adder (12) which adds +1,

$$\hat{q'de},$$

followed by a divider - by - 2 which generates value equal to 2, 1, 0 or -1.

3. Device according to claim 2,
characterized in that means for computing the elementary products consist of a circuit (44) which, depending on the value

$$\widehat{q'de},$$

makes it possible to carry out one of the following three functions on $\widehat{h}$ :
- transfer from the input to the output,
- shift of 1 bit towards the most significant bits,
- generation of zero on the output.

4. Echo canceller comprising means (34) for sampling signals qe transmitted on a line from a transmission-reception station and means (40) for sampling the signals received at the station on the line,

characterized in that comprises :

a digital computing device for computing in real time a sum of terms of the form :

$$\Sigma \widehat{g}(iT) \cdot q'de((n-i)T)$$

in which :

T designates a sampling period,

$\widehat{g}(iT)$ coefficients, and

q'de values which are computed from transmitted data qe which can only have values -3, -1, +3 and +1, equal to 1/2(qe+1), said device having means (12) for transforming the values samples qe into values q'de = 1/2(qe+1) which are powers of 2 ; means (44) for computing the elementary product obtained by possible shifts of $\widehat{g}$ depending upon the value of q'de ; an adder (22) having an input connected to the output of the means (44) for computing the elementary products and another output connected to the output of a summing register (24) whose input is connected to the output of the adder, for generating the sum of the elementary products ;

and a computing unit (38) receiving the samples of the received signals and the output of the register.

5. Echo cancellor according to claim 4,

characterized in that the means (44) for computing the elementary products comprise a circuit arranged for :
- transferring $\widehat{g}(iT)$ if q'de((n-i)T) is equal to +1 or -1, by changing the sign for value -1,
- shifting $\widehat{g}(iT)$ by one bit towards the most significant bits if q'de((n-i)T) is equal to +2,
- generating a zero on its output if q'de(n-i) is equal to zero.

**Patentansprüche**

1. Digitale Recheneinrichtung zur Berechnung einer Summe von Ausdrücken der Form

$$\sum \widehat{h}(iT) \cdot \widehat{q}e((n-i)T)$$

in Echtzeit, der

    T          die Abtastperiode,

    $\widehat{h}(iT)$     Koeffizienten und

                      $\widehat{q}e$

        die geschätzten Werte von ausgesendeten Daten qe, die nur die Werte -3, -1, +3 und +1 annehmen können.

bedeuten,

**gekennzeichnet durch**

Mittel zur Umwandlung der Werte

$$\hat{q}e$$

in Werte

$$\hat{q'}de,$$

die Potenzen von 2 sind, durch Addition oder Subtraktion derselben Zahl zu bzw. von allen Werten;
Mittel zur Berechnung der gewonnenen elementaren Produkte durch eventuelles Verschieben von $\hat{h}$ nach Maßgabe des Werts von

$$\hat{q'}de;$$

Mittel zur Bildung der Summe der elementaren Produkte und
Mittel, um gegebenenfalls der Summe eine Konstante hinzuzufügen, die eine Bewertung der auf die Änderung der Variablen zurückzuführenden Differenz der Ergebnisse darstellt.

2. Einrichtung nach Anspruch 1, dadurch gekennzeichnet, daß die Mittel zur Umwandlung der Werte

$$\hat{q}e$$

in Werte

$$\hat{q'}de$$

aus einem den Wert 1 hinzufügenden Addierer (12) und einem auf diesen folgenden 1:2-Teiler bestehen, der den Wert $\hat{q'}de = 2, 1, 0$ oder $-1$ bildet.

3. Einrichtung nach Anspruch 2, dadurch gekennzeichnet, daß die Mittel zur Berechnung der elementaren Produkte aus einer Schaltung (44) bestehen, die in Abhängigkeit von dem Wert $\hat{q'}de$ die Anwendung ein der drei folgenden Funktionen auf $\hat{h}$ ermöglichen:
   - Übertragen des Eingangssignals zum Ausgang,
   - Verschieben um 1 Bit in Richtung auf höheren Stellenwert,
   - Erzeugen von Null am Ausgang.

4. Echokompensator mit Mitteln (34) zum Abtasten der auf einer Leitung am Ausgang einer Sende/Empfangsstation abgegebenen Signale qe und Mitteln (40) zum Abtasten der über die Leitung an der Station empfangenen Signale
   **gekennzeichnet durch**
   eine digitale Recheneinrichtung, die in Echtzeit die Berechnung einer Summe von Ausdrücken der Form

$$\Sigma \, \hat{g}(iT) \cdot q'de((n-i)T)$$

ermöglicht, in der
   T             die Abtastperiode,
   $\hat{g}(iT)$     Koeffizienten und
   q'de          aus den ausgesendeten Daten berechnete Werte bedeuten, die nur die Werte -3, -1, +3
                 und +1, gleich $1/2(qe + 1)$ annehmen können,
   bedeuten,
   wobei die Einrichtung aufweist
   Mittel (12) zur Umwandlung der Werte der Abtastproben qe in Werte $q'de = 1/2 \cdot (qe + 1)$, die

Potenzen von 2 sind,

Mittel (44) zur Berechnung der elementaren Produkte, die in Abhängigkeit von dem Wert q'de durch eventuelle Verschiebungen von $\hat{g}$ gewonnen werden,

einen Addierer (22), von dessen Eingängen einer mit dem Ausgang der Mittel (44) zur Berechnung der elementaren Produkte und der andere mit dem Ausgang eines Akkumulator-Registers (24) verbunden ist, dessen Eingang mit dem Ausgang des Addierers so verbunden ist, daß die Summe der elementaren Produkte gebildet wird,

sowie ein Rechenorgan (3), das einerseits die Abtastproben der Eingangssignale und andererseits das Ausgangssignal des Registers aufnimmt.

5. Echokompensator nach Anspruch 4, dadurch gekennzeichnet, daß die Mittel (44) zur Berechnung der elementaren Produkte eine Schaltung umfassen, die
   - $\hat{g}$(iT) überträgt, wenn q'de((n-i)T) = +1 oder -1 ist, wobei für den Wert -1 das Vorzeichen geändert wird,
   - $\hat{g}$(iT) um 1 Bit in Richtung auf höheren Stellenwert verschiebt, wenn q'de((n-i)T) = +2 ist,
   - am Ausgang eine Null erzeugt, wenn q'de(n-i) = 0 ist.

FIG. 1

FIG. 2